# EUROPEAN PATENT SPECIFICATION

(11) **EP 3 951 857 B1**
(45) Date of publication and mention of the grant of the patent: **14.05.2025**
(21) Application number: 20782084.6
(22) Date of filing: 26.03.2020
(51) Int. Cl.: H01L 23/36, H01L 23/00, C04B 35/593, C04B 37/02, C04B 35/584, H01L 25/18, H01L 25/07, C04B 35/486

(54) **A METHOD FOR PRODUCING A SILICON NITRIDE SINTERED BODY**
VERFAHREN ZUR HERSTELLUNG EINES SINTERKÖRPERS AUS SILIZIUMNITRID
PROCÉDÉ DE PRODUCTION D'UN CORPS FRITTÉ EN NITRURE DE SILICIUM

(30) Priority: 29.03.2019 JP 2019066154
(43) Date of publication of application: 09.02.2022
(73) Proprietor: Denka Company Limited, Tokyo 103-8338 (JP)
(72) Inventor: IWAKIRI, Shoji, Tokyo 103-8338 (JP); TAKEDA, Makoto, Tokyo 103-8338 (JP); TAKADA, Shinichi, Tokyo 103-8338 (JP)
(74) Representative: Hoffmann Eitle
(86) International application number: PCT/JP2020/013787
(87) International publication number: WO 2020/203683

(56) References cited:
- CN-A- 108 774 066
- JP-A- 2002 265 276
- JP-A- 2002 293 641
- JP-A- 2007 197 229
- JP-A- H07 149 588
- JP-A- H11 100 273
- JP-A- H11 100 274
- JP-A- H11 130 543

## Description

### Technical Field

The present disclosure relates to a method for producing a silicon nitride sintered body.

### Background Art

Power modules that control a large current are used in fields related to automobiles, electric railways, industrial equipment, power generation, and the like. Ceramic substrates are used as insulating substrates mounted on power modules. In such applications, ceramic substrates are required to have favorable heat dissipation characteristics in addition to insulation property. For example, in Patent Literature 1, ceramic substrates made of a material containing aluminum nitride, alumina, silicon nitride, or silicon carbide as a main component have been proposed.

In addition, in Patent Literature 2, technology in which rare earth elements and Mg are added as components of a sintering aid to perform heat treatment under predetermined conditions and a silicon nitride sintered body having a thermal conductivity of greater than or equal to 100 W/(m·K) at normal temperature is produced has been proposed.

### Citation List

### Patent Literature

[Patent Literature 1] Japanese Unexamined Patent Publication No. 2017-212316
[Patent Literature 2] Japanese Unexamined Patent Publication No. 2006-96661 JP 2007 197229 A discloses a method for producing a silicon nitride sintered body.

### Summary of Invention

### Technical Problem

Since power modules are important parts that control various devices, it is required for the power modules to stably function. In order to improve the stability, not only is it necessary for each member constituting a power module to be reliable, but it is also necessary to reduce the amount of heat generation due to large currents. In order to satisfy such requirements, it is thought that it would be useful to use ceramic substrates which allow excellent heat dissipation and do not easily break even with a large number of heat cycles. However, in ceramic substrates in the related art, both excellent heat dissipation and high reliability are unlikely to be achieved.

In the present disclosure, a silicon nitride sintered body having both excellent heat dissipation and high reliability, and a method for producing the same are provided. In addition, in the present disclosure, a multilayer body including such a silicon nitride sintered body is provided. In addition, in the present disclosure, a power module including the above-described multilayer body is provided.

### Solution to Problem

A method for producing a silicon nitride sintered body according to an aspect of the present disclosure includes a step of molding a raw material powder containing silicon nitride and an oxide-based sintering aid to obtain a molded body, wherein a content of the oxide-based sintering aid in the raw material powder is 4.0 mass % to 8.0 mass%. An α-conversion rate of the silicon nitride contained in the raw material powder is 5 mass% to 20 mass%, and the silicon nitride sintered body has a fracture toughness K_{IC} of greater than 8 MPa·m^{1/2}. The method further include the step of firing the molded body at a firing temperature of 1,860°C to 2,100°C for 6 to 20 hours, the temperature increase rate to the firing temperature being 1.0 °C/hour to 10.0°C/hour If the α-conversion rate of the silicon nitride of the raw material powder is high, the grain growth rate in the firing step tends to be high. In this case, it is thought that, although sintering is promoted, the number of defects remaining in an obtained sintered body increases.

Whereas, if the α-conversion rate of the silicon nitride of the raw material powder is low, a β-conversion rate of the raw material powder tends to be high and the grain growth rate in the firing step tends to be low. In this case, it is thought that, although it takes time for sintering, the number of defects included in an obtained sintered body decreases, whereby thermal conductivity and fracture toughness improve. Regarding the silicon nitride sintered body obtained through the above-described production method, the silicon nitride sintered body having both excellent heat dissipation and high reliability due to such an action can be produced.

The silicon nitride sintered body obtained through the above-described production method has a thermal conductivity (at 20°C) of greater than 100 W/m·K and a fracture toughness (K_{IC}) of greater than or equal to 8 MPa·m^{1/2}. In addition, a transverse strength of the silicon nitride sintered body obtained through the above-described production method may exceed 600 MPa. Due to such characteristics, the heat dissipation and the reliability of the silicon nitride sintered body are further improved, and the silicon nitride sintered body can be more suitably used, for example, for a substrate of a power module.

A silicon nitride sintered body obtained according to the present method has a thermal conductivity (at 20°C) exceeding 100 W/m·K and a fracture toughness (K_{IC}) of greater than or equal to 8 MPa·m^{1/2}. Since this silicon nitride sintered body has excellent thermal conductivity and fracture toughness, it allows excellent heat dissipation and has high reliability. For this reason, the silicon nitride sintered body can be suitably used, for example, for a substrate of a power module.

In the above-described silicon nitride sintered body, a transverse strength may exceed 600 MPa. Due to such characteristics, the reliability of the silicon nitride sintered body is further improved, and the silicon nitride sintered body can be more suitably used, for example, for a substrate of a power module.

The thermal conductivity of the above-described silicon nitride sintered body at 150°C to 200°C may exceed 60 W/m·K. Accordingly, the silicon nitride sintered body can be more suitably used for a substrate of a power module to be used under particularly severe conditions.

A multilayer body may include: a metal layer made of a first metal; a heat dissipation portion made of a second metal having a thermal conductivity higher than that of the first metal; and a substrate which is provided between the metal layer and the heat dissipation portion and made of any of the above-described silicon nitride sintered bodies. The substrate of this multilayer body is made of a silicon nitride sintered body having both excellent heat dissipation and high reliability. This substrate is provided between the metal layer and the heat dissipation portion. For this reason, heat generated on the metal layer side can be efficiently radiated from the heat dissipation portion side. Accordingly, the substrate can be suitably used, for example, in a multilayer body for a power module.

A power module may include: the above-described multilayer body; and a semiconductor element electrically connected to the metal layer. Since such a power module includes the above-described substrate, it has excellent heat dissipation and reliability.

### Advantageous Effects of Invention

According to the present disclosure, a method for producing a silicon nitride sintered body having both excellent heat dissipation and high reliability can be provided. In addition, a multilayer body including such a silicon nitride sintered body can be obtained. In addition, a power module including the above-described multilayer body can be obtained.

### Brief Description of Drawings

FIG. 1 is a schematic cross-sectional view of a power module.
FIG. 2 is a view schematically illustrating a state of grain growth when sintering silicon nitride particles in one embodiment of a method for producing a silicon nitride sintered body.
FIG. 3 is a graph illustrating a relationship between firing temperatures and relative density.
FIG. 4 is a graph illustrating the change in thermal conductivity with temperature of silicon nitride sintered bodies of Example 1 and Comparative Example 1.
FIG. 5 is an electron micrograph of a fracture surface of the silicon nitride sintered body of Example 1.
FIG. 6 is a view schematically illustrating a state of grain growth when sintering silicon nitride particles in a method for producing a silicon nitride sintered body in the related art.
FIG. 7 is an electron micrograph of a fracture surface of a silicon nitride sintered body of Comparative Example 1.

### Description of Embodiments

Hereinafter, one embodiment of the present invention will be described with reference to the drawings according to circumstances. However, the following embodiments are merely examples for describing the present invention and are not intended to limit the present invention to the following contents. In the description, the same reference numerals are given to the same elements or elements having the same function, and description thereof will not be repeated according to circumstances. The dimensional ratios of elements are not limited to the ratios shown in the drawings.

A silicon nitride sintered body has a thermal conductivity exceeding 100 W/m·K at 20°C. The thermal conductivity (at 20°C) of the present disclosure can be measured according to JIS R 1611:2010. This thermal conductivity (at 20°C) is calculated by a calculation equation of A × B × C from values of a thermal diffusivity A [m²/second], a density B [kg/m³], and a specific heat C [J/(kg·K)]. The thermal diffusivity A is obtained through a laser flash method using a sample having a size of length × width × thickness = 10 mm × 10 mm × 2 mm. Specifically, the thermal diffusivity is obtained by an equation of A = 0.1388 × (thickness [mm])²/t_{1/2}. t_{1/2} is the time [seconds] required for increasing the temperature to half of ΔT when the total temperature rise width is set to ΔT. The density B is obtained through an Archimedes method. The specific heat C is obtained through differential thermal analysis.

The thermal conductivity (at 20°C) of the silicon nitride sintered body may be, for example, greater than 110 W/m·K, greater than 120 W/m·K, or greater than 140 W/m·K from the viewpoint of further improving the heat dissipation. The upper limit of the thermal conductivity (at 20°C) may be, for example, 200 W/m·K from the viewpoint of easiness of the production.

For example, the thermal conductivity of the silicon nitride sintered body at 150°C to 200°C may be greater than 60 W/m·K or greater than 65 W/m·K from the viewpoint of sufficiently increasing the heat dissipation when the silicon nitride sintered body is used in a power module or the like. The upper limit of the thermal conductivity at 150 °C to 200°C may be, for example, 150 W/m·K from the viewpoint of easiness of the production. The thermal conductivity in such a temperature range can also be obtained by the calculation equation of A × B × C as described above. At this time, the thermal diffusivity A may be a measurement value obtained by performing the above-described measurement at the temperature, and the specific heat C may be a literature value. A value at 20°C can be used as the density B as it is.

The silicon nitride sintered body has a fracture toughness (K_{IC}) of greater than 8 MPa·m^{1/2}. The fracture toughness (K_{IC}) is a value measured through an SEPB method and is measured according to JIS R 1607:2015. The fracture toughness (K_{IC}) of the silicon nitride sintered body is greater than 8 MPa·m^{1/2} from the viewpoint of further improving reliability. The upper limit of the fracture toughness (K_{IC}) may be, for example, 15 MPa·m^{1/2} from the viewpoint of easiness of the production.

The silicon nitride sintered body may have a transverse strength of greater than 600 MPa from the viewpoint of further improving reliability. The transverse strength is a three-point bending transverse strength and can be measured with a commercially available transverse strength meter according to JIS R 1601:2008. The transverse strength of the silicon nitride sintered body may exceed 620 MPa or exceed 650 MPa from the viewpoint of further improving reliability. The upper limit of the transverse strength may be, for example, 800 MPa from the viewpoint of easiness of the production.

The silicon nitride sintered body may substantially consist of only silicon nitride, or may contain components derived from a sintering aid and unavoidable components derived from raw materials, production processes, and the like. The content of silicon nitride in the silicon nitride sintered body may be, for example, greater than or equal to 90 mol%, greater than or equal to 95 mol%, or greater than or equal to 98 mol% from the viewpoint of achieving both high thermal conductivity and excellent insulation properties at a high level.

Since the amount of sintering aid to be used can be reduced to produce the silicon nitride sintered body, the total content of rare earth elements in the silicon nitride sintered body can be sufficiently reduced. The total content of rare earth elements in the silicon nitride sintered body may be less than or equal to 6.0 mass% or less than or equal to 3.0 mass%. 17 elements in total including the 2 elements of scandium (Sc) and yttrium (Y) and the 15 lanthanoid elements from lanthanum (La) to lutetium (Lu) correspond to the rare earth elements.

The silicon nitride sintered body may have a dielectric fracture strength of greater than or equal to 10 [kV/0.32 mm]. The dielectric fracture strength can be measured according to JIS C-2110:2016. The dielectric fracture strength may be, for example, greater than or equal to 11 [kV/0.32 mm]. The upper limit of the dielectric fracture strength may be, for example, 15 [kV/0.32 mm] from the viewpoint of easiness of the production.

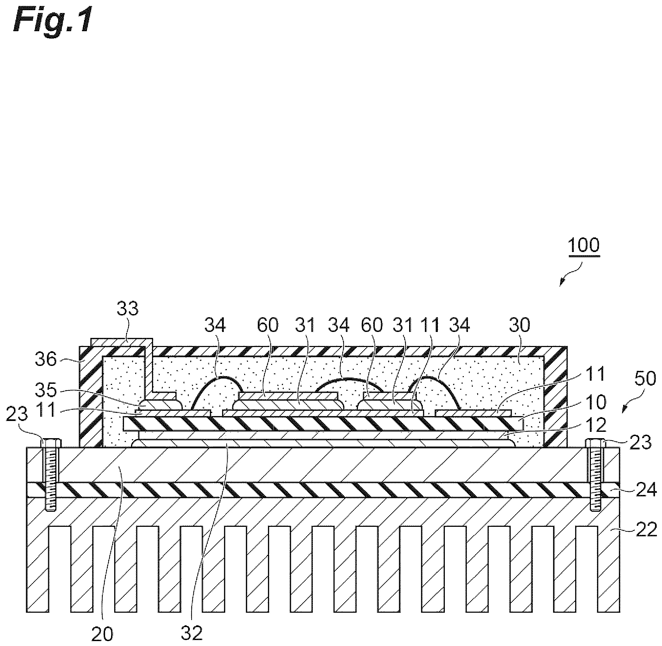

FIG. 1 is a schematic cross-sectional view of a power module. A power module 100 includes a metal layer 11, a substrate 10 (a silicon nitride sintered body 10), a metal layer 12, a solder layer 32, a base plate 20, and a cooling fin 22 in this order. The metal layer 11 constitutes a metal circuit through, for example, etching. A semiconductor element 60 is attached to the metal layer 11 via a solder layer 31. The semiconductor element 60 is connected to a predetermined portion of the metal layer 11 through a metal wire 34 such as an aluminum wire.

The substrate 10 is made of the silicon nitride sintered body. Accordingly, the metal layer 11 and the metal layer 12 are electrically insulated from each other. The metal layer 12 may or may not form an electrical circuit. The materials of the metal layer 11 and the metal layer 12 may be the same as or different from each other. The metal layer 11 and the metal layer 12 may be made of copper corresponding to a first metal. However, the materials thereof are not limited to copper.

The metal layer 12 is joined to the base plate 20 via the solder layer 32. The shape of the base plate 20 may be, for example, a substantially rectangular plate shape with length × width × thickness = 90 to 140 mm × 120 to 200 mm × 3 to 6 mm. A screw 23 for fixing the cooling fin 22 forming a heat dissipation member to the base plated 20 is provided at an end portion of the base plate. The base plate 20 may be made of aluminum corresponding to a second metal. The base plate 20 is joined to the cooling fin 22 via grease 24 on a side opposite to the metal layer 12 side.

The base plate 20 and the cooling fin 22 function as heat dissipation portions since these are made of the second metal having a thermal conductivity higher than that of the metal layer 11. Since the substrate 10 has a high thermal conductivity, the semiconductor element 60, the metal layer 11, and the metal layer 12 are efficiently cooled by the heat dissipation portions.

A resin case 36 is attached to one surface side (a side on which the semiconductor element 60 is installed) of the base plate 20 so as to accommodate the above-described members (the semiconductor element 60, the metal layers 11 and 12, and the substrate 10). The above-described members are accommodated in the space formed by the one surface of the base plate 20 and the case 36, and the space is filled with a filler 30 such as silicone gel so as to fill the gap. In order to electrically connect the exterior of the case 36 and the metal layer 11, a predetermined portion of the metal layer 11 is connected to an electrode 33 provided through the case 36 via a solder layer 35.

The power module 100 includes a multilayer body 50 consisting of the metal layer 11, the substrate 10, the metal layer 12, the base plate 20, and the cooling fin 22. The substrate 10 is made of the silicon nitride sintered body having both the high thermal conductivity and a high fracture toughness. Since the substrate 10 has a high thermal conductivity, heat can be smoothly radiated from the semiconductor element 60 and the metal layer 11 to the substrate 10 and the cooling fin 22. In addition, the silicon nitride sintered body is not easily broken even if it receives an impact. For this reason, the power module 100 can stably exhibit its performance and has excellent reliability. In this manner, the silicon nitride sintered body is suitably used for the substrate of the power module 100. However, use of the silicon nitride sintered body 10 is not limited to a power module.

The material of the base plate 20 is not limited to aluminum. For example, the base plate 20 may be made of the first metal (for example, copper), and only the cooling fin may be made of the second metal (such as aluminum). In this case, only the cooling fin 22 functions as a heat dissipation portion. In addition, there may be no cooling fin 22 and only the base plate 20 may function as a heat dissipation portion. Furthermore, there may be no metal layer 12 and the base plate 20 and the substrate 10 may be joined to each other.

The method for producing a silicon nitride sintered body will be described below. The method for producing the silicon nitride sintered body according to one embodiment includes a step of molding and firing a raw material powder containing silicon nitride. An α-conversion rate of silicon nitride contained in a raw material powder to be used is 5 mass% to 20 mass%. Accordingly, the grain growth rate of silicon nitride in the firing step can be slowed down. Accordingly, although it takes time for sintering, the number of defects remaining in the silicon nitride sintered body to be obtained can be decreased.

The α-conversion rate of silicon nitride contained in the raw material powder is less than or equal to 20 mass% or may be less than or equal to 15 mass% from the viewpoint of further increasing the thermal conductivity. The α-conversion rate of silicon nitride contained in the raw material powder is greater than or equal to 5 mass% from the viewpoint of increasing the transverse strength of the silicon nitride sintered body.

The raw material powder contains an oxide-based sintering aid in addition to silicon nitride. Examples of the oxide-based sintering aid include Y₂O₃, MgO, and Al₂O₃. The content of the oxide-based sintering aid in the raw material powder is 4.0 to 8.0 mass% or may be 4.0 to 5.0 mass% from the viewpoint of obtaining the silicon nitride sintered body capable of achieving both the high thermal conductivity and excellent insulation properties at a high level.

The above-described raw material powder is pressurized at, for example, a molding pressure of 3.0 to 10.0 MPa to obtain a molded body. The molded body may be produced through uniaxial pressurization or may be produced through CIP. In addition, the firing may be performed while performing molding through hot pressing. The firing of a molded body may be performed in an inert gas atmosphere of nitrogen gas, argon gas, or the like. The pressure during firing may be 0.7 to 0.9 MPa. The firing temperature is 1,860°C to 2,100°C or may be 1,880°C to 2,000°C. The firing time at the firing temperature is 6 to 20 hours or may be 8 to 16 hours. The temperature increase rate to the firing temperature is 1.0 °C/hour to 10.0 °C/hour.

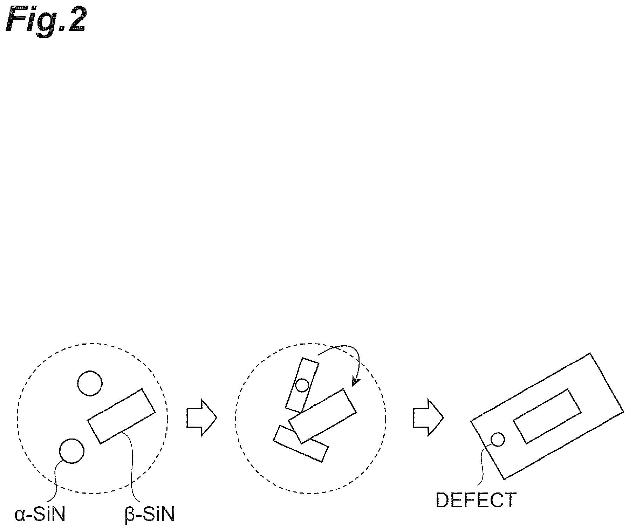

FIG. 2 is a view schematically illustrating a state of grain growth in the production method of the present embodiment when sintering silicon nitride particles. A melting point of β-SiN is higher than that of α-SiN and grain growth of β-SiN is slower than that of α-SiN. For this reason, the grain growth in a case where the α-conversion rate of silicon nitride contained in the raw material powder is low more slowly proceeds than a case where the α-conversion rate is high. For this reason, the number of defects remaining in grains is controlled in the process of grain growth of silicon nitride, and as a result, the silicon nitride sintered body having few defects is obtained as shown in FIG. 2. Such a silicon nitride sintered body has a high thermal conductivity and a high fracture toughness.

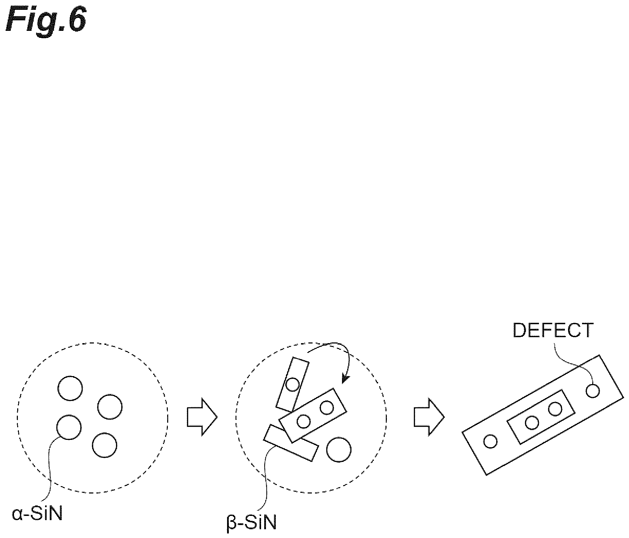

FIG. 6 is a view schematically illustrating a state of grain growth in a production method in the related art when sintering silicon nitride particles. In FIG. 6, the α-conversion rate of silicon nitride in a raw material powder is higher than that of FIG. 2. For this reason, α-SiN proceeds so as to complement grain growth of β-SiN in the process of grain growth of silicon nitride, and therefore, the grain growth rate of silicon nitride increases. As a result, the number of defects remaining in grains in the finally obtained the silicon nitride sintered body is larger than that of the case of FIG. 2. Such a silicon nitride sintered body has a lower thermal conductivity and fracture toughness than those of the silicon nitride sintered body obtained in FIG. 2.

Pores, lattice defects such as dislocations, and the like can be considered as the defects contained in the silicon nitride sintered body. The porosity of the silicon nitride sintered body may be, for example, less than or equal to 1.0 volume% or less than or equal to 0.5 volume%.

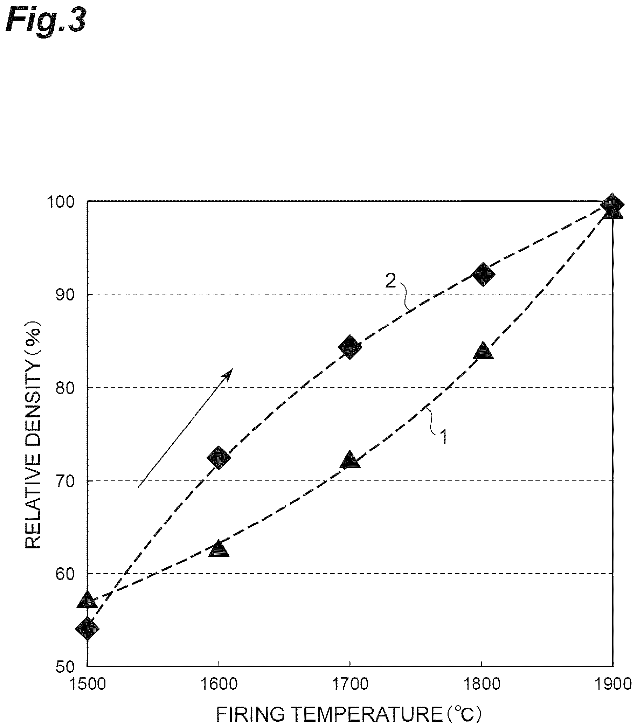

FIG. 3 is a graph illustrating an example of change in relative density of the silicon nitride sintered body depending on the firing temperature. In FIG. 3, a curve 1 shows change in relative density when a raw material powder containing silicon nitride having an α-conversion rate of 15 mass% is used. On the other hand, a curve 2 shows change in relative density when a raw material powder containing silicon nitride having an α-conversion rate of 93 mass% is used. As shown in FIG. 3, in the case where a raw material powder having a low α-conversion rate is used, the relative density increases slowly. This shows that the grain growth rate of silicon nitride is low. The silicon nitride sintered body obtained in this manner has a sufficiently reduced number of defects. In addition, the silicon nitride sintered body consists of large columnar crystal grains due to the crystal shape of β-SiN. It is thought that the silicon nitride sintered body has a high thermal conductivity and a high fracture toughness due to these factors.

Since the silicon nitride sintered body has a high thermal conductivity, it has an excellent heat dissipation. In addition, since the silicon nitride sintered body has a high fracture toughness, it can be stably used for a long period of time without a fracture even in a use environment subjected to a so-called heat cycle in which a high temperature and a low temperature are repeated. For this reason, the silicon nitride sintered body has excellent reliability. In this manner, since the silicon nitride sintered body has both excellent heat dissipation and excellent reliability, it can be suitably used as a substrate of a power module.

Some embodiments have been described above, but the present disclosure is not limited to any of the above-described embodiments.

### [Examples]

The contents of the present disclosure will be described in more detail with reference to examples and comparative examples, but the present disclosure is not limited to the following examples.

### (Examples 1)

### <Production of Silicon Nitride Sintered Body>

A silicon nitride powder (manufactured by Starck) having an α-conversion rate of 15 mass% was prepared. This silicon nitride powder and MgO and Y₂O₃ which were sintering aids were formulated at a ratio of Si₃N₄:MgO:Y₂O₃=95.2:1.5:3.3 (mass ratio) to obtain a raw material powder. This raw material powder was uniaxially pressed and molded at a pressure of 6.0 MPa to produce a columnar molded body.

This molded body was placed in an electric furnace equipped with a carbon heater, and the temperature was raised to 1,900°C at a rate of temperature increase of 2.1 °C/hour in a nitrogen gas atmosphere (pressure: 0.88 MPa). After firing was performed at a firing temperature of 1,900°C for 12 hours, the molded body was cooled at a temperature lowering rate of about 5.0 °C/hour to obtain a silicon nitride sintered body. The content of silicon nitride in the silicon nitride sintered body was 92 mol%.

### <Evaluation of Silicon Nitride Sintered Body>

The thermal conductivity (at 20°C) of the silicon nitride sintered body was measured according to JIS R 1611:2010. A thermal diffusivity A [m²/second] was obtained through a laser flash method using a sample having a size of length × width × thickness = 10 mm × 10 mm × 2 mm. A measurement device (device name: LFA447) manufactured by Netzch was used. A density B was measured through an Archimedes method, and a specific heat C was obtained through differential thermal analysis. The thermal conductivity was calculated by a calculation equation of A × B × C. The results are as shown in Table 1.

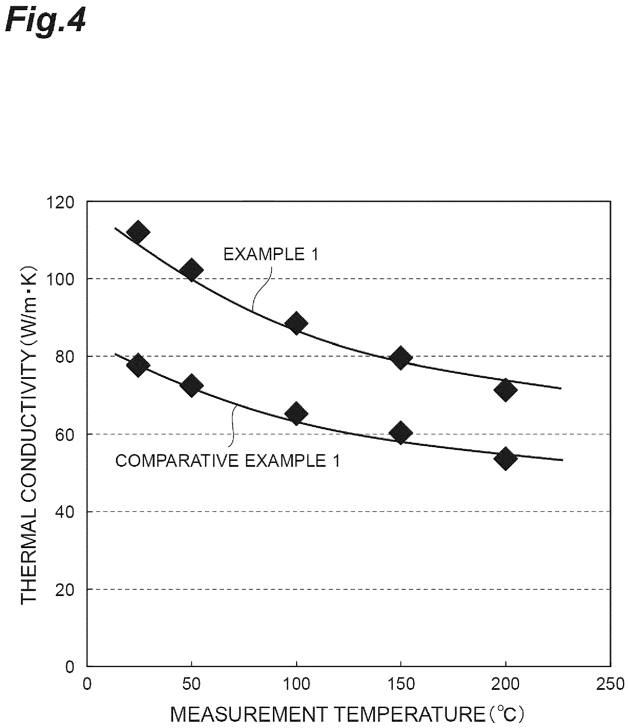

The thermal conductivity at 50°C to 200°C was measured in the same manner as the thermal conductivity at 20°C except that the thermal diffusivity A was measured at each temperature and a literature value was used as the specific heat C. These results are plotted in FIG. 4. The thermal conductivity at 20°C is also concurrently plotted in FIG. 4. As shown in FIG. 4, it was confirmed that the thermal conductivity decreased as the temperature increased. However, it was confirmed that the thermal conductivity of the silicon nitride sintered body of Example 1 was higher than that of Comparative Example 1 at any temperature.

A fracture toughness (K_{IC}) was a value measured through an SEPB method and was measured with a commercially available measurement device (manufactured by Instron, device name: Universal Testing Systems Type 5582) according to JIS R 1607:2015. The results are as shown in Table 1.

A transverse strength was a three-point bending transverse strength and was measured with a commercially available transverse strength meter (manufactured by Shimadzu Corporation, device name: AG-2000) according to JIS R 1601:2008. The results are as shown in Table 1.

A dielectric fracture strength was measured using a commercially available measurement device (manufactured by Keisoku Giken Co., Ltd., device name: 7474 type) according to JIS C-2110:2016. The results are as shown in Table 1.

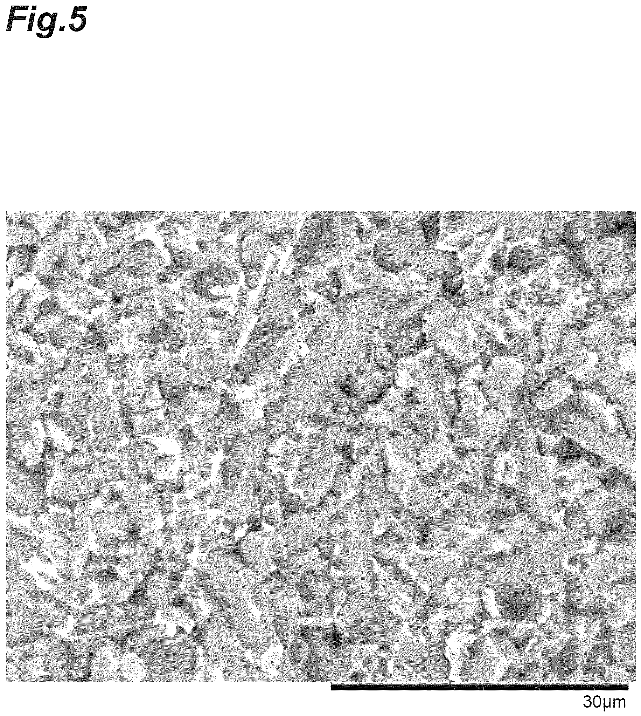

A fracture surface of the silicon nitride sintered body was observed with a scanning electron microscope (SEM). FIG. 5 is a photograph (magnification: 3,000 times) of the observation image with the SEM. The proportion of columnar crystals was high.

### (Comparative Example 1)

A silicon nitride sintered body was obtained in the same manner as in Example 1 except that a silicon nitride powder having an α-conversion rate of 93 mass% was used and fired at a firing temperature of 1,850°C for 4 hours. The obtained silicon nitride sintered body was evaluated in the same manner as in Example 1. The evaluation results are as shown in Table 1 and FIG. 4.

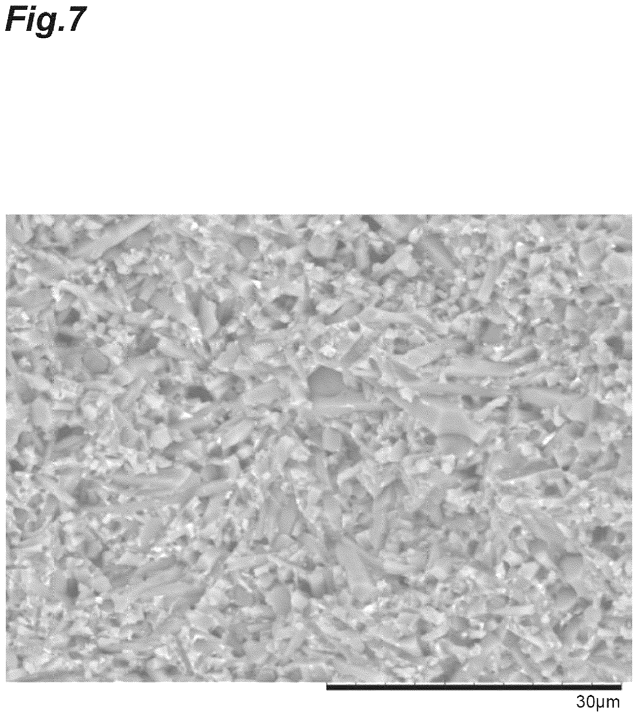

A fracture surface of the silicon nitride sintered body was observed with a scanning electron microscope (SEM). FIG. 7 is a photograph (magnification: 3,000 times) of the observation image with the SEM. The proportion of columnar crystals was smaller than that in FIG. 5, and the size of crystal grains was also smaller than that in FIG. 5.

**[Table 1]**

| Item | Unit | Example 1 | Comparative Example 1 |
|---|---|---|---|
| α-Conversion rate of silicon nitride of raw material powder | Mass% | 15 | 93 |
| Firing temperature | °C | 1,900 | 1,850 |
| Firing time | Time | 12 | 4 |
| Density | g/cm³ | 3.21 | 3.18 |
| Thermal conductivity (at 20°C) | W/m·K | 116 | 80 to 90 |
| Transverse strength | MPa | 620 | 750 |
| Fracture toughness | MPa·m^{1/2} | 8.1 | 6.3 |
| Dielectric fracture strength | kV/0.32 mm | 11.2 | 10.6 |

### (Examples 2 and 3 and Comparative Example)

Silicon nitride sintered bodies were obtained as shown in Table 2 in the same manner as in Example 1 except that silicon nitride powders having an α-conversion rate of 10 to 25 mass% were used. The obtained silicon nitride sintered bodies were evaluated in the same manner as in Example 1. The evaluation results are as shown in Table 2.

**[Table 2]**

| Item | Unit | Example 2 | Example 3 | Comparative Example |
|---|---|---|---|---|
| α-Conversion rate of silicon nitride of raw material powder | Mass% | 10 | 20 | 25 |
| Firing temperature | °C | 1,900 | 1,900 | 1,900 |
| Firing time | Time | 12 | 12 | 12 |
| Density | g/cm³ | 3.21 | 3.21 | 3.22 |
| Thermal conductivity (at 20°C) | W/m·K | 115 | 115 | 114 |
| Transverse strength | MPa | 620 | 631 | 644 |
| Fracture toughness | MPa·m^{1/2} | 8.2 | 8.1 | 7.8 |
| Dielectric fracture strength | kV/0.32 mm | 10 or more | 10 or more | 10 or more |

### (Comparative Examples 2 to 5)

Silicon nitride sintered bodies were obtained as shown in Table 3 in the same manner as in Example 1 except that silicon nitride powders having an α-conversion rate of 46 to 90 mass% were used. The obtained silicon nitride sintered bodies were evaluated in the same manners as in the examples. The evaluation results are as shown in Table 3.

**[Table 3]**

| Item | Unit | Comparative Example 2 | Comparative Example 3 | Comparative Example 4 | Comparative Example 5 |
|---|---|---|---|---|---|
| α-Conversionrate of silicon nitride of raw material powder | Mass% | 46 | 77 | 82 | 90 |
| Firing temperature | °C | 1,900 | 1,900 | 1,900 | 1,900 |
| Firing time | Time | 12 | 12 | 12 | 12 |
| Density | g/cm³ | 3.22 | 3.22 | 3.22 | 3.20 |
| Thermal conductivity (at 20°C) | W/m·K | 113 | 108 | 99 | 89 |
| Transverse strength | MPa | 682 | 769 | 751 | 760 |
| Fracture toughness | MPa·m^{1/2} | 7.3 | 7.2 | 7.0 | 6.8 |
| Dielectric fracture strength | kV/0.32 mm | 10 or more | 10 or more | 10 or more | 10 or more |

As shown in Tables 1 to 3, it was confirmed that the thermal conductivity can be increased by lowering the α-conversion rate of a silicon nitride powder used in a raw material powder.

### Industrial Applicability

According to the present disclosure, a silicon nitride sintered body having both excellent heat dissipation and high reliability, and a method for producing the same can be provided. In addition, according to the present disclosure, a multilayer body including such a silicon nitride sintered body can be provided. In addition, according to the present disclosure, a power module including the above-described multilayer body can be provided.

### Reference Signs List

10: Substrate (Silicon nitride sintered body), 11, 12: Metal layer, 30: Filler, 33: Electrode, 20: Base plate, 22: Cooling fin, 23: Screw, 24: Grease, 31, 32, 35: Solder layer, 34: Metal wire,
36: Case, 50: Multilayer body, 60: Semiconductor element, 100: Power module.

## Claims

1. A method for producing a silicon nitride sintered body, the method comprising:
a step of molding a raw material powder containing silicon nitride and an oxide-based sintering aid to obtain a molded body, and
a step of firing the molded body at a firing temperature of 1,860°C to 2,100°C for 6 to 20 hours, the temperature increase rate to the firing temperature being 1.0 °C/hour to 10.0°C/hour,
wherein an α-conversion rate of the silicon nitride contained in the raw material powder is 5 mass% to 20 mass%,
wherein a content of the oxide-based sintering aid in the raw material powder is 4.0 mass % to 8.0 mass%,
wherein the silicon nitride sintered body has a fracture toughness K_{IC} of greater than 8 MPa·m^{1/2}, and
wherein the fracture toughness K_{IC} is measured through an SEPB method according to JIS R 1607:2015.

2. The method for producing the silicon nitride sintered body according to claim 1,
wherein the silicon nitride sintered body has a thermal conductivity at 20°C of greater than 100 W/m·K, and
wherein the thermal conductivity is calculated using the calculation equation defined in the description.

3. The method for producing the silicon nitride sintered body according to claim 1 or 2,
wherein the molded body is obtained by pressurizing the raw material powder at a molding pressure of 3.0 to 10.0 MPa.

## Patentansprüche

1. Verfahren zur Herstellung eines Sinterkörpers aus Siliziumnitrid, wobei das Verfahren Folgendes umfasst:
einen Schritt des Formens eines Rohmaterialpulvers, das Siliziumnitrid und ein oxidbasiertes Sinterhilfsmittel enthält, um einen Formkörper zu erhalten, und
einen Schritt des Brennens des Formkörpers bei einer Brenntemperatur von 1.860 °C bis 2.100 °C für 6 bis 20 Stunden, wobei die Temperaturanstiegsrate auf die Brenntemperatur bei 1,0 °C/Stunde bis 10,0 °C/Stunde liegt,
wobei eine α-Umwandlungsrate des im Rohmaterialpulver enthaltenen Siliziumnitrids 5 Massenprozent bis 20 Massenprozent beträgt,
wobei ein Gehalt des oxidbasierten Sinterhilfsmittels im Rohmaterialpulver zwischen 4,0 Massenprozent und 8,0 Massenprozent beträgt,
wobei der Sinterkörper aus Siliziumnitrid eine Bruchzähigkeit K_{IC} von mehr als 8 MPa·m^{1/2} aufweist und
wobei die Bruchzähigkeit K_{IC} durch ein SEPB-Verfahren gemäß JIS R 1607:2015 gemessen wird.

2. Verfahren zur Herstellung des Sinterkörpers aus Siliziumnitrid nach Anspruch 1,
wobei der Sinterkörper aus Siliziumnitrid eine Wärmeleitfähigkeit bei 20 °C von mehr als 100 W/m·K aufweist und
wobei die Wärmeleitfähigkeit unter Verwendung der in der Beschreibung definierten Berechnungsgleichung berechnet wird.

3. Verfahren zur Herstellung des Sinterkörpers aus Siliziumnitrid nach Anspruch 1 oder 2,
wobei der Formkörper durch Druckbeaufschlagung des Rohmaterialpulvers mit einem Formdruck von 3,0 bis 10,0 MPa erhalten wird.

## Revendications

1. Procédé de production d'un corps fritté en nitrure de silicium, le procédé comprenant :
une étape destinée à mouler une poudre de matière première contenant du nitrure de silicium et un adjuvant de frittage à base d'oxyde pour obtenir un corps moulé, et
une étape destinée à cuire le corps moulé à une température de cuisson de 1860°C à 2100°C pendant 6 à 20 heures, la vitesse d'augmentation de température jusqu'à la température de cuisson étant de 1,0 °C/heure à 10,0°C/heure,
dans lequel un taux de conversion α du nitrure de silicium contenu dans la poudre de matière première est de 5 % en masse à 20 % en masse,
dans lequel une teneur en adjuvant de frittage à base d'oxyde dans la poudre de matière première est de 4,0 % en masse à 8,0 % en masse,
dans lequel le corps fritté en nitrure de silicium présente une ténacité à la rupture K_{IC} supérieure à 8 MPa·m^{1/2}, et
dans lequel la ténacité à la rupture K_{IC} est mesurée par une méthode SEPB selon la norme JIS R 1607:2015.

2. Procédé de production du corps fritté en nitrure de silicium selon la revendication 1,
dans lequel le corps fritté en nitrure de silicium présente une conductivité thermique à 20°C supérieure à 100 W/m·K, et
dans lequel la conductivité thermique est calculée en utilisant l'équation de calcul définie dans la description.

3. Procédé de production du corps fritté en nitrure de silicium selon la revendication 1 ou la revendication 2,
dans lequel le corps moulé est obtenu par pressurisation de la poudre de matière première à une pression de moulage de 3,0 à 10,0 MPa.
